# EUROPEAN PATENT APPLICATION

(11) **EP 4 521 567 A1**
(43) Date of publication of application: **12.03.2025**
(21) Application number: 24799471.8
(22) Date of filing: 08.02.2024
(51) Int. Cl.: H01S 5/068, H01S 5/30, H01S 5/22

(54) **EDGE-EMITTING SEMICONDUCTOR LIGHT-EMITTING STRUCTURE AND MANUFACTURING METHOD THEREFOR**

(30) Priority: 19.07.2023 CN 202310884837
(71) Applicant: Suzhou Everbright Photonics Co., Ltd., Suzhou, Jiangsu 215163 (CN); Everbright Institute of Semiconductor Photonics Co., Ltd., Suzhou, Jiangsu 215163 (CN)
(72) Inventor: WANG, Jun, Suzhou, Jiangsu 215163 (CN); TAN, Shaoyang, Suzhou, Jiangsu 215163 (CN); SHAO, Ye, Suzhou, Jiangsu 215163 (CN); LI, Quanling, Suzhou, Jiangsu 215163 (CN); MIN, Dayong, Suzhou, Jiangsu 215163 (CN)
(74) Representative: Lavoix
(86) International application number: PCT/CN2024/077051
(87) International publication number: WO 2025/015908

(57) **Abstract**

Disclosed are a light emitting structure of an edge emitting semiconductor, and a method for manufacturing same. The light emitting structure of an edge emitting semiconductor includes: a lower confinement layer, an active layer, and an upper confinement layer sequentially stacked on a semiconductor substrate layer; where the light emitting structure of an edge emitting semiconductor is provided with a first side wall and a second side wall oppositely arranged, and the first side wall and the second side wall are distributed in a slow axis direction of the light emitting structure of an edge emitting semiconductor; and the light emitting structure of an edge emitting semiconductor is provided with a current injection region positioned between the first side wall and the second side wall, and the current injection region is spaced apart from both the first side wall and the second side wall; and a feature trench positioned at least on one side of the current injection region in the slow axis direction; where the feature trench is positioned at least in the upper confinement layer, and the feature trench is provided with a feature side wall towards the current injection region; and a surface of the feature side wall is provided with a plurality of protrusions towards the current injection region. The light emitting structure of an edge emitting semiconductor can reduce power jitters.

## Description

### CROSS-REFERENCE TO RELATED APPLICATIONS

The disclosure claims the priority of Chinese Patent Application No. 2023108848376, filed with the Chinese Patent Office on July 19, 2023 and entitled "LIGHT EMITTING STRUCTURE OF EDGE EMITTING SEMICONDUCTOR, AND METHOD FOR MANUFACTURING SAME", which is incorporated in its entirety herein by reference.

### TECHNICAL FIELD

The disclosure relates to the technical field of semiconductors, and in particular to a light emitting structure of an edge emitting semiconductor, and a method for manufacturing same.

### BACKGROUND

High-power semiconductor laser chips develop towards higher output light power and higher brightness. By increasing a width of a light emitting region, a semiconductor laser chip having a wide waveguide is manufactured, which is an effective means of increasing the light power. For example, power of a semiconductor laser chip having a waveguide width of 100 microns-200 microns can be up to 20 W or higher. However, one problem brought about by an increase of the width of the light emitting region is that when the semiconductor laser chip operates, simultaneous lasing is caused in dozens or more high-order light modes in a lateral direction of the semiconductor laser chip, and the semiconductor laser chip may even have a light mode with an edge of the semiconductor laser chip as a boundary. In this case, the semiconductor laser chip will have serious power jitters. At present, existing methods for suppressing high-order modes include introducing anti-waveguide mode leaky structures on two sides of a wide waveguide, introducing light propagation loss structures at an edge of a waveguide, etc. These structures suppress high-order light modes propagating in the current injection region or near an edge of the current injection region, except for the light mode with an edge of the semiconductor laser chip as a boundary, and thus cannot solve the power jitters.

### SUMMARY OF THE INVENTION

Therefore, the technical problem to be solved by the disclosure is to provide a light emitting structure of an edge emitting semiconductor, and a method for manufacturing same, so as to solve power jitters of the light emitting structure of an edge emitting semiconductor.

The disclosure provides a light emitting structure of an edge emitting semiconductor. The light emitting structure includes: a semiconductor substrate layer; a lower confinement layer, an active layer, and an upper confinement layer sequentially stacked on the semiconductor substrate layer; where the light emitting structure of an edge emitting semiconductor is provided with a first side wall and a second side wall oppositely arranged, and the first side wall and the second side wall are distributed in a slow axis direction of the light emitting structure of an edge emitting semiconductor; and the light emitting structure of an edge emitting semiconductor is provided with a current injection region positioned between the first side wall and the second side wall, and the current injection region is spaced apart from both the first side wall and the second side wall; and a feature trench positioned at least on one side of the current injection region in the slow axis direction; where the feature trench is positioned at least in the upper confinement layer, the feature trench is provided with a feature side wall towards the current injection region, and the feature side wall and the current injection region are spaced apart in the slow axis direction; and a surface of the feature side wall is provided with a plurality of protrusions towards the current injection region.

Optionally, the feature side wall is a diffuse reflection side wall.

Optionally, the protrusions on the surface of the feature side wall are strip-shaped; the surface of the feature side wall is further provided with strip-shaped recesses between adjacent protrusions; and vertices of any adjacent protrusions on the surface of the feature side wall are staggered in the slow axis direction, and/or distances between vertices of any adjacent protrusions on the surface of the feature side wall in a light emitting direction are unequal to one another. Optionally, the plurality of protrusions on the surface of the feature side wall are distributed in dots at uneven intervals.

Optionally, the feature side wall of the feature trench has an intersection line with a sectional plane parallel to an upper surface of the semiconductor substrate layer, a plurality of randomly-distributed points are provided on the intersection line at intervals, and adjacent randomly-distributed points on the intersection line have different coordinates in the slow axis direction, and also have different coordinates in a light emitting direction of the semiconductor substrate layer.

Optionally, the intersection line is a curve or a polygonal line.

Optionally, the plurality of randomly-distributed points provided on the intersection line at intervals includes a first randomly-distributed point to an Mth randomly-distributed point, and M is an integer greater than or equal to 2; and a position of any ith randomly-distributed point satisfies yᵢ=y₀+h*δₖ, and xᵢ=L/M*(i+δₖ'), δₖ denotes a first random distribution function, h denotes a random-range width of a diffuse scattering trench, i denotes an integer greater than or equal to 1 and less than or equal to M, yᵢ denotes a coordinate of the ith randomly-distributed point in the slow axis direction, xᵢ denotes a coordinate of the ith randomly-distributed point in a light emitting direction of the semiconductor substrate layer, y₀ denotes an average value of coordinates of the first randomly-distributed point to the Mth randomly-distributed point in the slow axis direction, L denotes a fixed value less than or equal to a cavity length of the light emitting structure of an edge emitting semiconductor, and δₖ' denotes a second random distribution function.

Optionally, a value of the first random distribution function is a random number in a range from -0.5 to 0.5, and a value of the second random distribution function is a random number in a range from -0.5 to 0.5.

Optionally, h≥λ/2n, λ denotes an operating wavelength of the light emitting structure of an edge emitting semiconductor, and n denotes an effective refractive index of the current injection region.

Optionally, the protrusions on the surface of the feature side wall are strip-shaped; the surface of the feature side wall is further provided with strip-shaped recesses between adjacent protrusions, and the protrusions and the recesses on the surface of the feature side wall are arranged periodically in a light emitting direction of the light emitting structure of an edge emitting semiconductor; and a period length d of the arrangement of the protrusions and the recesses is greater than or equal to λ/2n, λ denotes an operating wavelength of the light emitting structure of an edge emitting semiconductor, and n denotes an effective refractive index of the current injection region.

Optionally, a length direction of the protrusions is perpendicular to the light emitting direction of the light emitting structure of an edge emitting semiconductor; and alternatively, a length direction of the protrusions is not perpendicular to the light emitting direction of the light emitting structure of an edge emitting semiconductor.

Optionally, a ratio of a maximum variation value, between corresponding coordinates in the slow axis direction of the protrusions and the recesses within one period length on the surface of the feature side wall, to the period length d is greater than or equal to 0.1.

Optionally, the feature trench is positioned only on one side of the current injection region in the slow axis direction.

Optionally, feature trenches are positioned on two sides of the current injection region in the slow axis direction respectively.

Optionally, a distance from the feature side wall of the feature trench to an edge of the current injection region is greater than or equal to 10 microns.

Optionally, the light emitting structure further includes: a lower waveguide layer positioned between the active layer and the lower confinement layer; and an upper waveguide layer positioned between the upper confinement layer and the active layer; where the feature trench is positioned at least in the upper waveguide layer and the upper confinement layer.

Optionally, the feature trench is positioned in the upper waveguide layer and the upper confinement layer, and does not extend into the active layer; alternatively, the feature trench is positioned in the upper waveguide layer, the upper confinement layer, and the active layer, and does not extend into the lower waveguide layer; alternatively, the feature trench is positioned in the upper waveguide layer, the upper confinement layer, the active layer, and the lower waveguide layer, and does not extend into the lower confinement layer; and alternatively, the feature trench is positioned in the upper waveguide layer, the upper confinement layer, the active layer, the lower waveguide layer, and the lower confinement layer, and does not extend into the semiconductor substrate layer.

Optionally, a depth of the feature trench on one side of the current injection region is consistent with a depth of the feature trench on the other side of the current injection region, or not consistent therewith.

Optionally, the light emitting structure of an edge emitting semiconductor is provided with a front cavity surface and a rear cavity surface oppositely arranged, the front cavity surface is connected to both the first side wall and the second side wall, the rear cavity surface is connected to both the first side wall and the second side wall; and the feature trench is positioned between the front cavity surface and the rear cavity surface.

Optionally, the feature trench is spaced apart from both the front cavity surface and the rear cavity surface.

Optionally, the diffuse reflection side wall of the feature trench is connected to the front cavity surface and/or the rear cavity surface.

Optionally, the light emitting structure further includes: a first etched trench and a second etched trench that are positioned in part of the upper confinement layer in a thickness direction thereof, and a portion, between the first etched trench and the second etched trench, of the upper confinement layer forms a ridge region; the ridge region and portions, under the ridge region, of the lower confinement layer, the lower waveguide layer, the active layer, the upper waveguide layer, and the upper confinement layer serve as the current injection region; and the feature trench is positioned at the bottom of the first etched trench and/or the bottom of the second etched trench.

The disclosure further provides a method for manufacturing a light emitting structure of an edge emitting semiconductor. The method includes: providing a semiconductor substrate layer; sequentially forming a lower confinement layer, an active layer, and an upper confinement layer that are stacked on the semiconductor substrate layer; where the light emitting structure of an edge emitting semiconductor is provided with a first side wall and a second side wall oppositely arranged, and the first side wall and the second side wall are distributed in a slow axis direction of the light emitting structure of an edge emitting semiconductor; and the light emitting structure of an edge emitting semiconductor is provided with a current injection region positioned between the first side wall and the second side wall, and the current injection region is spaced apart from both the first side wall and the second side wall; and forming a feature trench at least on one side of the current injection region in the slow axis direction; where the feature trench is positioned at least in the upper confinement layer, the feature trench is provided with a feature side wall towards the current injection region, and the feature side wall and the current injection region are spaced apart in the slow axis direction; and a surface of the feature side wall is provided with a plurality of protrusions towards the current injection region.

Optionally, the method further includes: forming a first etched trench and a second etched trench in part of the upper confinement layer in a thickness direction thereof before the feature trench is formed, where a portion, between the first etched trench and the second etched trench, of the upper confinement layer forms a ridge region; the ridge region and portions, under the ridge region, of the lower confinement layer, the lower waveguide layer, the active layer, the upper waveguide layer, and the upper confinement layer serve as the current injection region; and the step of forming a feature trench includes: forming the feature trench at the bottom of the first etched trench and/or the bottom of the second etched trench.

Optionally, the method further includes: forming a lower waveguide layer on one side, facing away from the semiconductor substrate layer, of the lower confinement layer before the active layer is formed; and forming an upper waveguide layer on one side, facing away from the semiconductor substrate layer, of the active layer before the upper confinement layer is formed; where in the step of forming a feature trench at least on one side of the current injection region in the slow axis direction, the feature trench is formed to be positioned at least in the upper waveguide layer and the upper confinement layer.

The technical solutions of the disclosure have the beneficial effects as follows:
In the light emitting structure of an edge emitting semiconductor according to the technical solution of the disclosure, the feature trench is arranged and positioned at least in the upper confinement layer, the feature trench is provided with the feature side wall towards the current injection region, and the feature side wall and the current injection region are distributed in the slow axis direction. The feature side wall of the feature trench prevents light from propagating to the first side wall and/or the second side wall. Accordingly, lasing in a light mode with the first side wall, the second side wall, the front cavity surface, and the rear cavity surface as boundaries is avoided, resonance of light between the front cavity surface and the rear cavity surface is further increased, more light is emergent from the front cavity surface, and power jitters are reduced.

Further, the feature side wall is the diffuse reflection side wall, and light is randomly scattered at the diffuse reflection side wall. Therefore, lasing in the light mode with the first side wall, the second side wall, the front cavity surface, and the rear cavity surface as boundaries is effectively avoided.

Further, the protrusions on the surface of the feature side wall are strip-shaped, and a length direction of the protrusions is parallel to a fast axis direction of the light emitting structure of an edge emitting semiconductor; the surface of the feature side wall is further provided with the strip-shaped recesses between adjacent protrusions, and the protrusions and the recesses on the surface of the feature side wall are arranged periodically in the light emitting direction of the light emitting structure of an edge emitting semiconductor; and one period length d of the arrangement of the protrusions and the recesses is greater than or equal to λ/2n, λ denotes the operating wavelength of the light emitting structure of an edge emitting semiconductor, and n denotes an effective refractive index of the current injection region. Light can be emitted or diffracted at the feature side wall. Therefore, lasing in the laser mode with the first side wall, the second side wall, the front cavity surface, and the rear cavity surface as boundaries is effectively avoided.

### BRIEF DESCRIPTION OF THE DRAWINGS

In order to describe the technical solutions in particular embodiments of the disclosure or the prior art more clearly, the accompanying drawings required for describing the particular embodiments or the prior art are briefly described below. Apparently, the accompanying drawings in the following description show some embodiments of the disclosure. Those of ordinary skill in the art can also derive other accompanying drawings from these accompanying drawings without creative efforts.
FIG 1 is a schematic diagram of a light emitting structure of an edge emitting semiconductor according to an example of the disclosure;
FIG 2 is a schematic sectional view taken along a cutting line W1-W2 in FIG 1;
FIG 3 is a schematic diagram of a light emitting structure of an edge emitting semiconductor according to another example of the disclosure;
FIG 4 is a schematic diagram of a light emitting structure of an edge emitting semiconductor according to yet another example of the disclosure;
FIG 5 is a schematic diagram of a light emitting structure of an edge emitting semiconductor according to yet another example of the disclosure;
FIG 6 is a schematic diagram of a diffuse scattering trench arrangement region in the light emitting structure of an edge emitting semiconductor in FIG 4;
FIG 7 is a top view of a light emitting structure of an edge emitting semiconductor according to yet another example of the disclosure; and
FIG 8 is a stereo schematic structural diagram of a light emitting structure of an edge emitting semiconductor according to still another example of the disclosure.

### DETAILED DESCRIPTION

The disclosure provides a light emitting structure of an edge emitting semiconductor. The light emitting structure includes: a semiconductor substrate layer; a lower confinement layer, an active layer, and an upper confinement layer sequentially stacked on the semiconductor substrate layer; where the light emitting structure of an edge emitting semiconductor is provided with a first side wall and a second side wall oppositely arranged, and the first side wall and the second side wall are distributed in a slow axis direction of the light emitting structure of an edge emitting semiconductor; and the light emitting structure of an edge emitting semiconductor is provided with a current injection region positioned between the first side wall and the second side wall, and the current injection region is spaced apart from both the first side wall and the second side wall; and a feature trench positioned at least on one side of the current injection region in the slow axis direction; where the feature trench is positioned at least in the upper confinement layer, the feature trench is provided with a feature side wall towards the current injection region, and the feature side wall and the current injection region are spaced apart in the slow axis direction; and a surface of the feature side wall is provided with a plurality of protrusions towards the current injection region.

The technical solutions of the disclosure are clearly and completely described below with reference to the accompanying drawings. Apparently, examples described are merely some examples rather than all examples of the disclosure. Based on the examples of the disclosure, all other examples derived by those of ordinary skill in the art without creative efforts fall within the scope of protection of the disclosure.

In the description of the disclosure, it should be noted that the orientation or position relations indicated by the terms "center", "upper", "lower", "left", "right", "vertical", "horizontal", "inside", "outside", etc. are based on the orientation or position relations shown in the accompanying drawings, are merely for facilitating the description of the disclosure and simplifying the description, rather than indicating or implying that the device or element referred to must have a particular orientation or be constructed and operated in a particular orientation, and therefore cannot be interpreted as limiting the disclosure. In addition, the terms "first", "second", and "third" are merely for description, and cannot be interpreted as indicating or implying relative importance.

In the description of the disclosure, it should be noted that the terms "mount", "connect", and "connection" should be understood in a broad sense, for example, they can denote a fixed connection, a detachable connection, an integrated connection, a mechanical connection, an electrical connection, a direct connection, an indirect connection via an intermediate medium, or communication inside two elements, unless explicitly specified and defined otherwise. For those of ordinary skill in the art, the specific meanings of the above terms in the disclosure can be understood according to specific circumstances.

In addition, the technical features involved in different embodiments of the disclosure and described below can be combined with one another without conflicts.

### Example 1

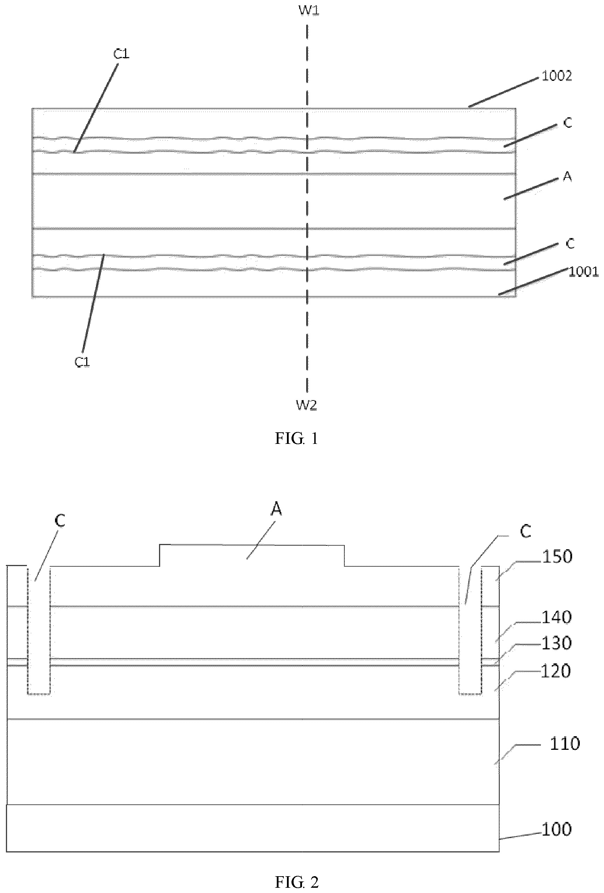

A light emitting structure of an edge emitting semiconductor is provided in the example. With reference to FIGs. 1 and 2, the light emitting structure includes:
a semiconductor substrate layer 100;
a lower confinement layer 110, a lower waveguide layer 120, an active layer 130, an upper waveguide layer 140, and an upper confinement layer 150 sequentially stacked on the semiconductor substrate layer 100; where
the light emitting structure of an edge emitting semiconductor is provided with a first side wall 1001 and a second side wall 1002 oppositely arranged, and the first side wall 1001 and the second side wall 1002 are distributed in a slow axis direction of the light emitting structure of an edge emitting semiconductor; and the light emitting structure of an edge emitting semiconductor is provided with a current injection region A positioned between the first side wall 1001 and the second side wall 1002, and the current injection region A is spaced apart from both the first side wall 1001 and the second side wall 1002; and
a feature trench C positioned at least on one side of the current injection region A in the slow axis direction; where the feature trench C is positioned at least in the upper confinement layer 150, the feature trench C is provided with a feature side wall C1 towards the current injection region A, and the feature side wall C1 is a diffuse reflection side wall; and a surface of the feature side wall C1 is provided with a plurality of protrusions towards the current injection region A, and the feature side wall C1 and the current injection region A are spaced apart in the slow axis direction.

Further, the feature trench C is positioned at least in the upper waveguide layer 140 and the upper confinement layer 150.

In the example, the diffuse reflection side wall of the feature trench C prevents light from propagating to the first side wall 1001 and/or the second side wall 1002. Light is randomly scattered at the diffuse reflection side wall. Therefore, lasing in a light mode with the first side wall 1001, the second side wall 1002, a front cavity surface, and a rear cavity surface as boundaries is effectively avoided. Resonance of light between the front cavity surface and the rear cavity surface is further increased, more light is emergent from the front cavity surface, and power jitters are reduced.

The light emitting structure of an edge emitting semiconductor is, for example, an edge emitting semiconductor laser.

A length of the feature trench C extends in a direction from the front cavity surface to the rear cavity surface. A width direction of the feature trench C is parallel to the slow axis direction.

In an example, a distance from the feature side wall C1 of the feature trench C to an edge of the current injection region A is greater than or equal to 10 microns, and is, for example, 12 microns or 15 microns. If the distance from the feature side wall C1 of the feature trench C to the edge of the current injection region A is too small, some low-order mode light in the current injection region A is lost.

In the example, with reference to FIG 1, feature trenches C are positioned on two sides of the current injection region A in the slow axis direction respectively. In this way, an extent by which the light is randomly scattered at the feature side wall C1 is further enhanced.

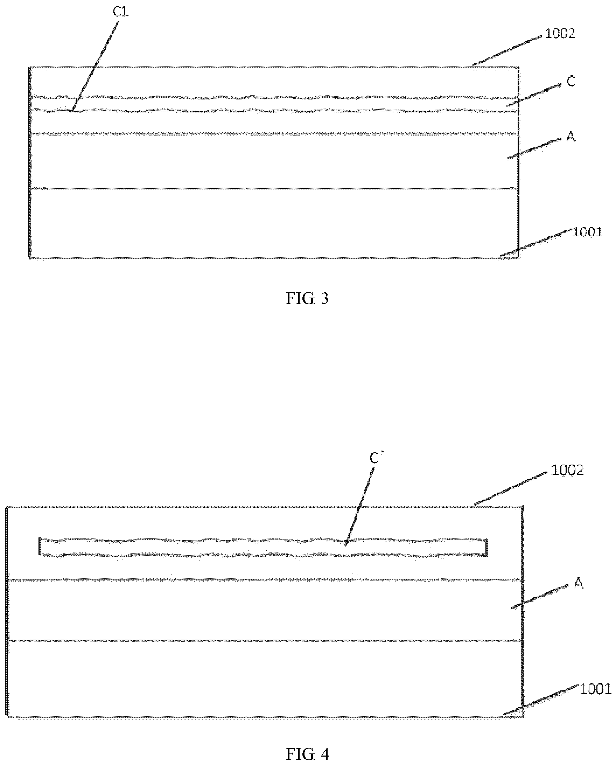

In another example, with reference to FIG 3, the feature trench C is positioned only on one side of the current injection region A in the slow axis direction. In FIG 3, the feature trench C is positioned only between the current injection region A and the second side wall 1002. In other examples, the feature trench is positioned only between the current injection region and the first side wall.

In the example, with reference to FIG 2, the feature trench C is positioned in the upper waveguide layer 140, the upper confinement layer 150, the active layer 130, and the lower waveguide layer 120, and does not extend into the lower confinement layer 110. Specifically, the feature trench C is positioned in the upper waveguide layer 140, the upper confinement layer 150, the active layer 130, and part of the lower waveguide layer 120, and does not extend into the lower confinement layer 110.

In another example, the feature trench is positioned in the upper waveguide layer, the upper confinement layer, the active layer, and the lower waveguide layer, and a bottom surface of the feature trench is positioned at an interface between the lower confinement layer and the lower waveguide layer.

In other examples, the feature trench is positioned in the upper waveguide layer and the upper confinement layer, and does not extend into the active layer; alternatively, the feature trench is positioned in the upper waveguide layer, the upper confinement layer, and the active layer, and does not extend into the lower waveguide layer; and alternatively, the feature trench is positioned in the upper waveguide layer, the upper confinement layer, the active layer, the lower waveguide layer, and the lower confinement layer, and does not extend into the semiconductor substrate layer.

When extending from the upper confinement layer 150 to at least the lower waveguide layer 120, the feature trench C scatters light propagating in the lower waveguide layer 120 and the upper waveguide layer 140. Therefore, the extent by which the light is randomly scattered at the feature side wall C1 is further enhanced.

In the example, a depth of the feature trench C on one side of the current injection region A is consistent with a depth of the feature trench C on the other side of the current injection region A. In other examples, a depth of the feature trench on one side of the current injection region is not consistent with a depth of the feature trench on the other side of the current injection region.

The light emitting structure of an edge emitting semiconductor is provided with the front cavity surface and the rear cavity surface oppositely arranged, the front cavity surface is connected to both the first side wall and the second side wall, and the rear cavity surface is connected to both the first side wall and the second side wall; and the feature trench is positioned between the front cavity surface and the rear cavity surface.

With reference to FIGs. 1 and 3, the feature side wall C1 of the feature trench C is connected to both the front cavity surface and the rear cavity surface.

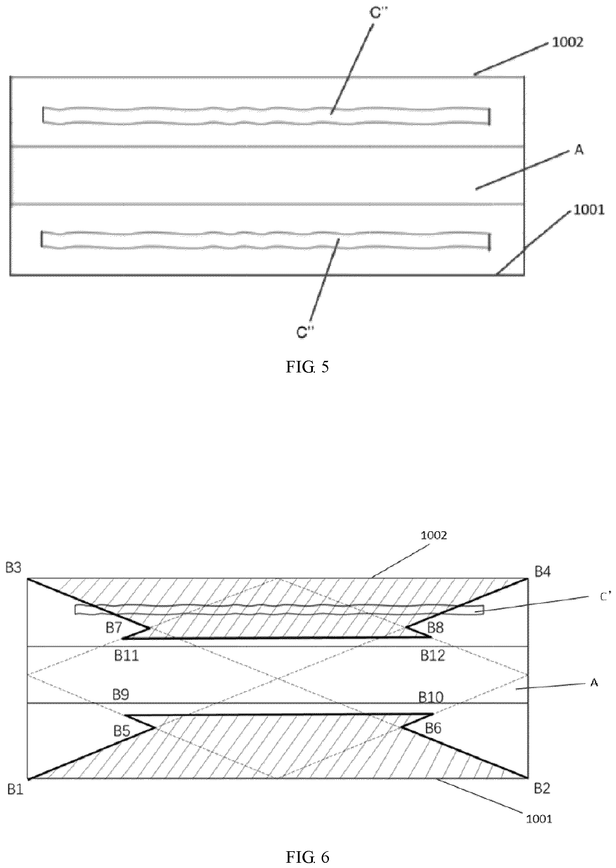

In other examples, with reference to FIG 4, the feature trench C' is spaced apart from the front cavity surface and the rear cavity surface. With reference to FIG 5, the feature trench C" is spaced apart from the front cavity surface and the rear cavity surface.

In other examples, the feature side wall of the feature trench is connected to both the front cavity surface or the rear cavity surface.

The light emitting structure of an edge emitting semiconductor further includes: an insulating medium layer (not shown) positioned in the feature trench.

In an example, the insulating medium layer has a smaller refractive index than the lower confinement layer, the lower waveguide layer, the active layer, the upper waveguide layer, and the upper confinement layer. In this way, light emitted from the current injection region towards the first side wall and the second side wall is further confined, so that power jitters are further reduced.

In other examples, the refractive index of the insulating medium layer is not limited.

In an example, the insulating medium layer is made of silicon oxide, silicon nitride, or aluminum oxide.

In an example, no medium fills the feature trench, and the feature trench is of a hollow structure.

The feature side wall C1 of the feature trench C has an intersection line with a sectional plane parallel to an upper surface of the semiconductor substrate layer 100, a plurality of randomly-distributed points are provided on the intersection line at intervals, and adjacent randomly-distributed points on the intersection line have different coordinates in the slow axis direction, and also have different coordinates in a light emitting direction of the semiconductor substrate layer.

The intersection line is a curve or a polygonal line.

The plurality of randomly-distributed points provided on the intersection line at intervals include a first randomly-distributed point to an Mth randomly-distributed point, and M is an integer greater than or equal to 2. A position of any ith randomly-distributed point satisfies yᵢ=y₀+h*δₖ, and xᵢ=L/M*(i+δₖ'), δₖ denotes a first random distribution function, h denotes a random-range width of a diffuse scattering trench, i denotes an integer greater than or equal to 1 and less than or equal to M, yᵢ denotes a coordinate of the ith randomly-distributed point in the slow axis direction, xᵢ denotes a coordinate of the ith randomly-distributed point in a light emitting direction of the semiconductor substrate layer, y₀ denotes an average value of coordinates of the first randomly-distributed point to the Mth randomly-distributed point in the slow axis direction, L denotes a fixed value less than or equal to a cavity length of the light emitting structure of an edge emitting semiconductor, and δₖ' denotes a second random distribution function. Specifically, h equals a difference between a maximum and a minimum of the coordinates of the first randomly-distributed point to the Mth randomly-distributed point in the slow axis direction.

In an example, a value of the first random distribution function is a random number in a range from -0.5 to 0.5, and a value of the second random distribution function is a random number in a range from -0.5 to 0.5.

In an example, h≥λ/2n, λ denotes an operating wavelength of the light emitting structure of an edge emitting semiconductor, and n denotes an effective refractive index of the current injection region. The advantage is to increase a diffuse reflection extent.

In an example, the protrusions on the surface of the feature side wall are strip-shaped; the surface of the feature side wall is further provided with strip-shaped recesses between adjacent protrusions; and vertices of any adjacent protrusions on the surface of the feature side wall are staggered in the slow axis direction, and/or distances between vertices of any adjacent protrusions on the surface of the feature side wall in a light emitting direction are unequal to one another. A length direction of the protrusions is perpendicular to the light emitting direction of the light emitting structure of an edge emitting semiconductor; and alternatively, a length direction of the protrusions is not perpendicular to the light emitting direction of the light emitting structure of an edge emitting semiconductor, and the length direction of the protrusions is not parallel to the light emitting direction of the light emitting structure of a semiconductor.

In another example, the plurality of protrusions on the surface of the feature side wall are distributed in dots at uneven intervals.

In an example, when the feature trenches C are positioned on two sides of the current injection region A in the slow axis direction, the feature side walls C1 on the two sides of the current injection region A have a first intersection line and a second intersection line with the same sectional plane respectively, and the first intersection line and the second intersection line are positioned on the two sides of the current injection region A respectively. In a specific example, coordinates of any ith randomly-distributed point on the first intersection line in the light emitting direction of the semiconductor substrate layer are different from coordinates of any ith randomly-distributed point on the second intersection line in the light emitting direction of the semiconductor substrate layer. In another specific example, coordinates of any ith randomly-distributed point on the first intersection line in the light emitting direction of the semiconductor substrate layer are identical to coordinates of any ith randomly-distributed point on the second intersection line in the light emitting direction of the semiconductor substrate layer.

With reference to FIG 2, the light emitting structure of an edge emitting semiconductor further includes: a first etched trench and a second etched trench that are positioned in part of the upper confinement layer 150 in a thickness direction thereof, and a portion, between the first etched trench and the second etched trench, of the upper confinement layer forms a ridge region; the ridge region and portions, under the ridge region, of the lower confinement layer, the lower waveguide layer, the active layer, the upper waveguide layer, and the upper confinement layer serve as the current injection region A; and the feature trench C is positioned at the bottom of the first etched trench and the bottom of the second etched trench. In other examples, the feature trench is positioned at the bottom of the first etched trench and/or the bottom of the second etched trench.

The feature trench is provided with a secondary side wall on one side facing away from the current injection region, the secondary side wall is a secondary diffuse reflection side wall, and alternatively, the secondary side wall is a plane.

With reference to FIG 6, the light emitting structure of an edge emitting semiconductor has a feature plane parallel to both the light emitting direction and the slow axis direction, the feature plane intersects the feature trench C', and the feature plane has a first vertex point B1, a second vertex point B2, a third vertex point B3, and a fourth vertex point B4; and an outer contour of the feature plane includes a first edge, a second edge, a third edge, and a fourth edge, where the first edge and the second edge are oppositely arranged, the third edge and the fourth edge are oppositely arranged, the first edge is connected to the third edge and the fourth edge, and the second edge is connected to the third edge and the fourth edge. The first edge is an intersection line between the first side wall 1001 and the feature plane, the second edge is an intersection line between the second side wall 1002 and the feature plane, the third edge is an intersection line between the front cavity surface and the feature plane, and the fourth edge is an intersection line between the rear cavity surface and the feature plane. The first vertex point B1 is a point of the intersection line between the first side wall 1001 and the front cavity surface in the feature plane, and is also an intersection point of the first edge and the third edge; the second vertex point B2 is a point of the intersection line between the first side wall 1001 and the rear cavity surface in the feature plane, and is also an intersection point of the first edge and the fourth edge; the third vertex point B3 is a point of the intersection line between the second side wall 1002 and the front cavity surface in the feature plane, and is also an intersection point of the second edge and the third edge; and the fourth vertex point B4 is a point of the intersection line between the second side wall 1002 and the rear cavity surface in the feature plane, and is also an intersection point of the second edge and the fourth edge.

The feature plane has a fifth feature point B5, a sixth feature point B6, a seventh feature point B7, an eighth feature point B8, a ninth feature point B9, a tenth feature point B10, an eleventh feature point B11, and a twelfth feature point B12 internally. The fifth feature point B5 is an intersection point of a connection line from a midpoint of the first edge to a midpoint of the third edge intersecting a connection line from the first vertex point B1 to the fourth vertex point B4; the sixth feature point B6 is an intersection point of a connection line from the midpoint of the first edge to a midpoint of the fourth edge intersecting a connection line from the third vertex point B3 to the second vertex point B2; the seventh feature point B7 is an intersection point of a connection line from a midpoint of the second edge to the midpoint of the third edge intersecting a connection line from the third vertex point B3 to the second vertex point B2; the eighth feature point B8 is an intersection point of a connection line from the midpoint of the second edge to the midpoint of the fourth edge intersecting a connection line from the first vertex point B1 to the fourth vertex point B4; the ninth feature point B9 is positioned on the connection line from the midpoint of the first edge to the midpoint of the third edge, and a distance from the ninth feature point to the side wall of the current injection region A is greater than or equal to a threshold distance; the tenth feature point B10 is positioned on the connection line from the midpoint of the first edge to the midpoint of the fourth edge, and a distance from the tenth feature point to a side wall of the current injection region A is greater than or equal to the threshold distance; the eleventh feature point B11 is positioned on the connection line from the midpoint of the second edge to the midpoint of the third edge, and a distance from the eleventh feature point to the side wall of the current injection region A is greater than or equal to the threshold distance; and the twelfth feature point B12 is positioned on the connection line from the midpoint of the second edge to the midpoint of the fourth edge, and a distance from the twelfth feature point to the side wall of the current injection region A is greater than or equal to the threshold distance. The first vertex point B1, the fifth feature point B5, and the ninth feature point B9 are sequentially connected to form a first polygonal line, the second vertex point B2, the sixth feature point B6, and the tenth feature point B10 are sequentially connected to form a second polygonal line, the third vertex point B3, the seventh feature point B7, and the eleventh feature point B11 are sequentially connected to form a third polygonal line, and the fourth vertex point B4, the eighth feature point B8, and the twelfth feature point B12 are sequentially connected to form a fourth polygonal line.

When the feature trench C' is positioned between the second side wall 1002 and the current injection region A, the feature trench C' spans over the third polygonal line and the fourth polygonal line in a length direction thereof.

When the feature trench is positioned between the first side wall and the current injection region, the feature trench spans over the first polygonal line and the second polygonal line in a length direction thereof.

With the above positional arrangement of the feature trench, propagation of light along all parallelograms formed by connecting one point in the first edge, one point in the third edge, one point in the second edge, and one point in the fourth edge sequentially is effectively destroyed.

### Example 2

The example differs from Example 1 in that a light emitting structure of an edge emitting semiconductor in the example includes: a lower confinement layer, an active layer, and an upper confinement layer sequentially stacked on a semiconductor substrate layer; where the light emitting structure of an edge emitting semiconductor is provided with a first side wall and a second side wall oppositely arranged, and the first side wall and the second side wall are distributed in a slow axis direction of the light emitting structure of an edge emitting semiconductor; and the light emitting structure of an edge emitting semiconductor is provided with a current injection region positioned between the first side wall and the second side wall, and the current injection region is spaced apart from both the first side wall and the second side wall; and a feature trench positioned at least on one side of the current injection region in the slow axis direction; where the feature trench is positioned at least in the upper confinement layer, the feature trench is provided with a feature side wall towards the current injection region; and a surface of the feature side wall is provided with a plurality of protrusions towards the current injection region. The light emitting structure of an edge emitting semiconductor in the example differs from that in Example 1 in that the light emitting structure of an edge emitting semiconductor includes no lower waveguide layer or upper waveguide layer.

The feature trench is positioned in the upper confinement layer, and does not extend into the active layer; alternatively, the feature trench is positioned in the upper confinement layer and the active layer, and does not extend into the lower confinement layer; and alternatively, the feature trench is positioned in the upper confinement layer, the active layer, and the lower confinement layer, and does not extend into the semiconductor substrate layer.

Reference may be made to Example 1 for other descriptions of the light emitting structure of an edge emitting semiconductor in the example, which will not be repeated.

### Example 3

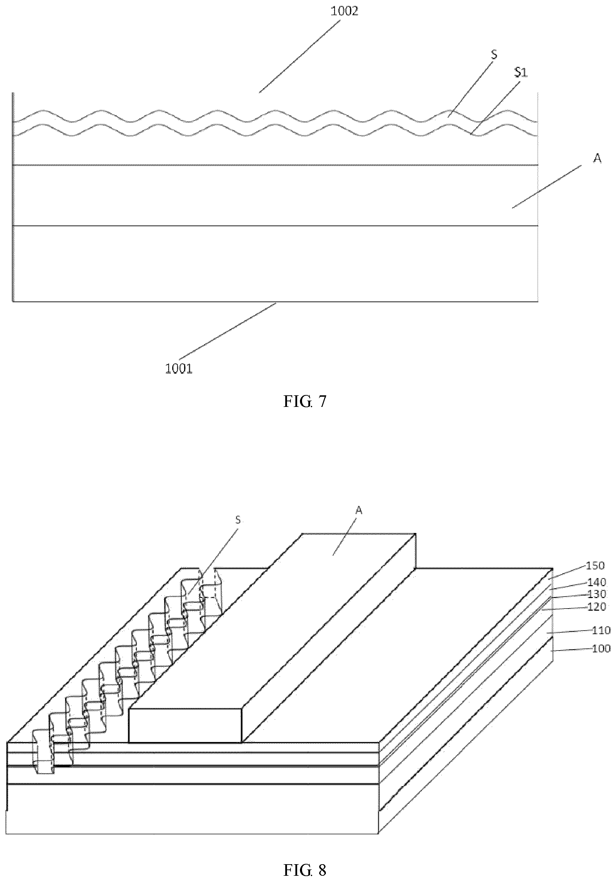

With reference to FIG 7 and 8, FIG 8 is a stereo schematic structural diagram corresponding to FIG 7. In the example, a feature trench S is provided with a feature side wall S1 towards a current injection region A, and protrusions on a surface of the feature side wall S1 are strip-shaped; and the surface of the feature side wall S1 is further provided with strip-shaped recesses between adjacent protrusions. The example differs from Example 1 in that the protrusions and the recesses on the surface of the feature side wall S1 are arranged periodically in a light emitting direction of the light emitting structure of an edge emitting semiconductor; and a period length d of the arrangement of the protrusions and the recesses is greater than or equal to λ/2n, λ denotes an operating wavelength of the light emitting structure of an edge emitting semiconductor, and n denotes an effective refractive index of the current injection region.

A length direction of the protrusions is perpendicular to the light emitting direction of the light emitting structure of an edge emitting semiconductor; and alternatively, a length direction of the protrusions is not perpendicular to the light emitting direction of the light emitting structure of an edge emitting semiconductor, and the length direction of the protrusions is not parallel to the light emitting direction of the light emitting structure of a semiconductor. In FIG 8, the length direction of the protrusions being perpendicular to the light emitting direction of the light emitting structure of an edge emitting semiconductor is taken as an example.

With a long period length, light emitted from the current injection region A is diffracted at the surface of the feature side wall S1. Therefore, lasing in a light mode with a first side wall 1001, a second side wall 1002, a front cavity surface, and a rear cavity surface as boundaries is effectively avoided.

In an example, a distance from the feature side wall S1 of the feature trench S to an edge of the current injection region A is greater than or equal to 10 microns, and is, for example, 12 microns or 15 microns.

In an example, a ratio of a maximum variation value, between corresponding coordinates in a slow axis direction of the protrusions and the recesses within one period length on the surface of the feature side wall S1, to the period length d is greater than or equal to 0.1. With a great ratio, the feature side wall S1 has a strong capacity to change a direction of a light path.

In FIGs. 7 and 8, the feature trench S being positioned only on one side of the current injection region A in the slow axis direction is taken as an example. In other examples, the feature trenches are positioned on two sides of the current injection region A in the slow axis direction respectively.

Reference may be made to the description in Example 1 for a depth position of the feature trench, which will not be repeated.

When the feature trench extends from the upper confinement layer 150 to at least the lower waveguide layer 120, the feature trench diffracts light propagating in the lower waveguide layer 120 and the upper waveguide layer 140. Therefore, an extent by which the light is diffracted at the feature side wall S1 is further enhanced.

The feature trenches are positioned on two sides of the current injection region A in the slow axis direction respectively, and a depth of the feature trench on one side of the current injection region A is consistent with a depth of the feature trench on the other side of the current injection region A, or not consistent therewith.

The light emitting structure of an edge emitting semiconductor is provided with a front cavity surface and a rear cavity surface oppositely arranged, the front cavity surface is connected to both the first side wall and the second side wall, and the rear cavity surface is connected to both the first side wall and the second side wall; and the feature trench is positioned between the front cavity surface and the rear cavity surface.

In FIGs. 7 and 8, the feature side wall S1 of the feature trench S being connected to both the front cavity surface and the rear cavity surface is taken as an example. In other examples, the feature trench C is spaced apart from both the front cavity surface and the rear cavity surface. In other examples, the feature side wall of the feature trench is connected to the front cavity surface or the rear cavity surface.

The light emitting structure of an edge emitting semiconductor further includes: an insulating medium layer (not shown) positioned in the feature trench. Reference may be made to the description in Example 1 for a material of the insulating medium layer. In other examples, no medium fills the feature trench, and the feature trench is of a hollow structure.

With reference to FIG 2, the light emitting structure of an edge emitting semiconductor further includes: a first etched trench and a second etched trench that are positioned in part of the upper confinement layer 150 in a thickness direction thereof, and a portion, between the first etched trench and the second etched trench, of the upper confinement layer 150 forms a ridge region; the ridge region and portions, under the ridge region, of the lower confinement layer 110, the lower waveguide layer 120, the active layer 130, the upper waveguide layer 140, and the upper confinement layer 150 serve as the current injection region A; and the feature trenches S are positioned at the bottom of the first etched trench or the bottom of the second etched trench separately. In other examples, the feature trench is positioned at the bottom of the first etched trench and the bottom of the second etched trench.

The feature trench is provided with a secondary side wall on one side facing away from the current injection region, the secondary side wall is a plane, and alternatively, the secondary side wall has the same shape as the feature side wall.

### Example 4

The example differs from Example 3 in that a light emitting structure of an edge emitting semiconductor includes no lower waveguide layer or upper waveguide layer.

A feature trench is positioned in an upper confinement layer, and does not extend into an active layer; alternatively, a feature trench is positioned in an upper confinement layer and an active layer, and does not extend into a lower confinement layer; and alternatively, a feature trench is positioned in an upper confinement layer, an active layer, and a lower confinement layer, and does not extend into a semiconductor substrate layer.

Reference may be made to Example 3 for other descriptions of the light emitting structure of an edge emitting semiconductor in the example, which will not be repeated.

### Example 5

The disclosure further provides a method for manufacturing a light emitting structure of an edge emitting semiconductor. The method includes: a semiconductor substrate layer is provided; a lower confinement layer, an active layer, and an upper confinement layer that are stacked are sequentially formed on the semiconductor substrate layer; where the light emitting structure of an edge emitting semiconductor is provided with a first side wall and a second side wall oppositely arranged, the first side wall and the second side wall are distributed in a slow axis direction of the light emitting structure of an edge emitting semiconductor, the light emitting structure of an edge emitting semiconductor is provided with a current injection region positioned between the first side wall and the second side wall, and the current injection region is spaced apart from both the first side wall and the second side wall; and a feature trench is formed at least on one side of the current injection region in the slow axis direction; where the feature trench is positioned at least in the upper confinement layer, the feature trench is provided with a feature side wall towards the current injection region, and the feature side wall and the current injection region are spaced apart in the slow axis direction; and a surface of the feature side wall is provided with a plurality of protrusions towards the current injection region.

Further, the feature trench is formed to be positioned at least in the upper waveguide layer and the upper confinement layer.

The method for manufacturing a light emitting structure of an edge emitting semiconductor further includes: a lower waveguide layer is formed on one side, facing away from the semiconductor substrate layer, of the lower confinement layer before the active layer is formed; and an upper waveguide layer is formed on one side, facing away from the semiconductor substrate layer, of the active layer before the upper confinement layer is formed; where in the step that a feature trench is formed at least on one side of the current injection region in the slow axis direction, the feature trench is formed to be positioned at least in the upper waveguide layer and the upper confinement layer.

The method for manufacturing a light emitting structure of an edge emitting semiconductor further includes: a first etched trench and a second etched trench are formed in part of the upper confinement layer in a thickness direction thereof before the feature trench is formed, where a portion, between the first etched trench and the second etched trench, of the upper confinement layer forms a ridge region; the ridge region and portions, under the ridge region, of the lower confinement layer, the lower waveguide layer, the active layer, the upper waveguide layer, and the upper confinement layer serve as the current injection region; and the step that a feature trench is formed includes: the feature trench is formed at the bottom of the first etched trench and/or the bottom of the second etched trench.

In an example, a diffuse scattering trench is formed through a wet etching process.

Reference may be made to the foregoing example for the description of the feature trench.

Apparently, the above examples are merely illustrative for the clear description, and are not intended to limit the embodiments. Those of ordinary skill in the art can also make changes and variations in different forms on the basis of the above descriptions. It is unnecessary and impossible to list all the embodiments herein. The obvious changes or variations derived therefrom still fall within the scope of protection of the disclosure.

## Claims

1. A light emitting structure of an edge emitting semiconductor, comprising:
a semiconductor substrate layer;
a lower confinement layer, an active layer, and an upper confinement layer sequentially stacked on the semiconductor substrate layer; wherein
the light emitting structure of an edge emitting semiconductor is provided with a first side wall and a second side wall oppositely arranged, and the first side wall and the second side wall are distributed in a slow axis direction of the light emitting structure of an edge emitting semiconductor; and the light emitting structure of an edge emitting semiconductor is provided with a current injection region positioned between the first side wall and the second side wall, and the current injection region is spaced apart from both the first side wall and the second side wall; and
a feature trench positioned at least on one side of the current injection region in the slow axis direction; wherein the feature trench is positioned at least in the upper confinement layer, the feature trench is provided with a feature side wall towards the current injection region, and the feature side wall and the current injection region are spaced apart in the slow axis direction; and a surface of the feature side wall is provided with a plurality of protrusions towards the current injection region.

2. The light emitting structure of an edge emitting semiconductor according to claim 1, wherein the feature side wall is a diffuse reflection side wall.

3. The light emitting structure of an edge emitting semiconductor according to claim 2, wherein the protrusions on the surface of the feature side wall are strip-shaped; the surface of the feature side wall is further provided with strip-shaped recesses between adjacent protrusions; and vertices of any adjacent protrusions on the surface of the feature side wall are staggered in the slow axis direction, and/or distances between vertices of any adjacent protrusions on the surface of the feature side wall in a light emitting direction are unequal to one another.

4. The light emitting structure of an edge emitting semiconductor according to claim 2, wherein the plurality of protrusions on the surface of the feature side wall are distributed in dots at uneven intervals.

5. The light emitting structure of an edge emitting semiconductor according to claim 2, wherein the feature side wall of the feature trench has an intersection line with a sectional plane parallel to an upper surface of the semiconductor substrate layer, a plurality of randomly-distributed points are provided on the intersection line at intervals, and adjacent randomly-distributed points on the intersection line have different coordinates in the slow axis direction, and also have different coordinates in a light emitting direction of the semiconductor substrate layer.

6. The light emitting structure of an edge emitting semiconductor according to claim 5, wherein the intersection line is a curve or a polygonal line.

7. The light emitting structure of an edge emitting semiconductor according to claim 5, wherein the plurality of randomly-distributed points provided on the intersection line at intervals comprise a first randomly-distributed point to an Mth randomly-distributed point, and M is an integer greater than or equal to 2; and a position of any ith randomly-distributed point satisfies yᵢ=y₀+h*δₖ, and Xᵢ=L/M*(i+δₖ'), δₖ denotes a first random distribution function, h denotes a random-range width of the feature trench, i denotes an integer greater than or equal to 1 and less than or equal to M, yᵢ denotes a coordinate of the ith randomly-distributed point in the slow axis direction, xᵢ denotes a coordinate of the ith randomly-distributed point in a light emitting direction of the semiconductor substrate layer, y₀ denotes an average value of coordinates of the first randomly-distributed point to the Mth randomly-distributed point in the slow axis direction, L denotes a fixed value less than or equal to a cavity length of the light emitting structure of an edge emitting semiconductor, and δₖ' denotes a second random distribution function.

8. The light emitting structure of an edge emitting semiconductor according to claim 7, wherein a value of the first random distribution function is a random number in a range from -0.5 to 0.5, and a value of the second random distribution function is a random number in a range from -0.5 to 0.5.

9. The light emitting structure of an edge emitting semiconductor according to claim 7, wherein h≥λ/2n, λ denotes an operating wavelength of the light emitting structure of an edge emitting semiconductor, and n denotes an effective refractive index of the current injection region.

10. The light emitting structure of an edge emitting semiconductor according to claim 1, wherein the protrusions on the surface of the feature side wall are strip-shaped; the surface of the feature side wall is further provided with strip-shaped recesses between adjacent protrusions, and the protrusions and the recesses on the surface of the feature side wall are arranged periodically in a light emitting direction of the light emitting structure of an edge emitting semiconductor; and a period length d of the arrangement of the protrusions and the recesses is greater than or equal to λ/2n, λ denotes an operating wavelength of the light emitting structure of an edge emitting semiconductor, and n denotes an effective refractive index of the current injection region.

11. The light emitting structure of an edge emitting semiconductor according to claim 3 or 10, wherein a length direction of the protrusions is perpendicular to the light emitting direction of the light emitting structure of an edge emitting semiconductor; and alternatively, a length direction of the protrusions is not perpendicular to the light emitting direction of the light emitting structure of an edge emitting semiconductor, and the length direction of the protrusions is not parallel to the light emitting direction of the light emitting structure of a semiconductor.

12. The light emitting structure of an edge emitting semiconductor according to claim 10, wherein a ratio of a maximum variation value, between corresponding coordinates in the slow axis direction of the protrusions and the recesses within one period length on the surface of the feature side wall, to the period length d is greater than or equal to 0.1.

13. The light emitting structure of an edge emitting semiconductor according to claim 1, wherein the feature trench is positioned only on one side of the current injection region in the slow axis direction.

14. The light emitting structure of an edge emitting semiconductor according to claim 1, wherein feature trenches are positioned on two sides of the current injection region in the slow axis direction respectively.

15. The light emitting structure of an edge emitting semiconductor according to claim 1, wherein a distance from the feature side wall of the feature trench to an edge of the current injection region is greater than or equal to 10 microns.

16. The light emitting structure of an edge emitting semiconductor according to claim 1, further comprising: a lower waveguide layer positioned between the active layer and the lower confinement layer; and an upper waveguide layer positioned between the upper confinement layer and the active layer; wherein the feature trench is positioned at least in the upper waveguide layer and the upper confinement layer.

17. The light emitting structure of an edge emitting semiconductor according to claim 16, wherein the feature trench is positioned in the upper waveguide layer and the upper confinement layer, and does not extend into the active layer; alternatively, the feature trench is positioned in the upper waveguide layer, the upper confinement layer, and the active layer, and does not extend into the lower waveguide layer; alternatively, the feature trench is positioned in the upper waveguide layer, the upper confinement layer, the active layer, and the lower waveguide layer, and does not extend into the lower confinement layer; and alternatively, the feature trench is positioned in the upper waveguide layer, the upper confinement layer, the active layer, the lower waveguide layer, and the lower confinement layer, and does not extend into the semiconductor substrate layer.

18. The light emitting structure of an edge emitting semiconductor according to claim 14, wherein a depth of the feature trench on one side of the current injection region is consistent with a depth of the feature trench on the other side of the current injection region, or not consistent therewith.

19. The light emitting structure of an edge emitting semiconductor according to claim 1, wherein the light emitting structure of an edge emitting semiconductor is provided with a front cavity surface and a rear cavity surface oppositely arranged, the front cavity surface is connected to both the first side wall and the second side wall, the rear cavity surface is connected to both the first side wall and the second side wall; and the feature trench is positioned between the front cavity surface and the rear cavity surface.

20. The light emitting structure of an edge emitting semiconductor according to claim 19, wherein the feature trench is spaced apart from both the front cavity surface and the rear cavity surface.

21. The light emitting structure of an edge emitting semiconductor according to claim 19, wherein the feature side wall of the feature trench is connected to the front cavity surface and/or the rear cavity surface.

22. The light emitting structure of an edge emitting semiconductor according to claim 1 or 16, further comprising: a first etched trench and a second etched trench that are positioned in part of the upper confinement layer in a thickness direction thereof, and a portion, between the first etched trench and the second etched trench, of the upper confinement layer forms a ridge region; the ridge region and portions, under the ridge region, of the lower confinement layer, the lower waveguide layer, the active layer, the upper waveguide layer, and the upper confinement layer serve as the current injection region; and the feature trench is positioned at the bottom of the first etched trench and/or the bottom of the second etched trench.

23. The light emitting structure of an edge emitting semiconductor according to claim 1, wherein the light emitting structure of an edge emitting semiconductor has a feature plane parallel to both a light emitting direction and the slow axis direction, an outer contour of the feature plane comprises a first edge and a second edge oppositely arranged, and a third edge and a fourth edge oppositely arranged, the first edge is connected to both the third edge and the fourth edge, the second edge is connected to both the third edge and the fourth edge, the first edge is an intersection line between the first side wall and the feature plane, the second edge is an intersection line between the second side wall and the feature plane, the third edge is an intersection line between a front cavity surface and the feature plane, and the fourth edge is an intersection line between a rear cavity surface and the feature plane; the first edge intersects the third edge to form a first vertex point, the first edge intersects the fourth edge to form a second vertex point, the second edge intersects the third edge to form a third vertex point, and the second edge intersects the fourth edge to form a fourth vertex point; an intersection point of a connection line from a midpoint of the first edge to a midpoint of the third edge intersecting a connection line from the first vertex point to the fourth vertex point is a fifth feature point; an intersection point of a connection line from the midpoint of the first edge to a midpoint of the fourth edge intersecting a connection line from the third vertex point to the second vertex point is a sixth feature point; an intersection point of a connection line from a midpoint of the second edge to the midpoint of the third edge intersecting a connection line from the third vertex point to the second vertex point is a seventh feature point; an intersection point of a connection line from the midpoint of the second edge to the midpoint of the fourth edge intersecting a connection line from the first vertex point to the fourth vertex point is an eighth feature point; a ninth feature point is provided on the connection line from the midpoint of the first edge to the midpoint of the third edge, and a distance from the ninth feature point to a side wall of the current injection region in the slow axis direction is greater than or equal to a threshold distance; a tenth feature point is provided on the connection line from the midpoint of the first edge to the midpoint of the fourth edge, and a distance from the tenth feature point to the side wall of the current injection region in the slow axis direction is greater than or equal to the threshold distance; an eleventh feature point is provided on the connection line from the midpoint of the second edge to the midpoint of the third edge, and a distance from the eleventh feature point to the side wall of the current injection region in the slow axis direction is greater than or equal to the threshold distance; a twelfth feature point is provided on the connection line from the midpoint of the second edge to the midpoint of the fourth edge, and a distance from the twelfth feature point to the side wall of the current injection region in the slow axis direction is greater than or equal to the threshold distance; and the first vertex point, the fifth feature point, and the ninth feature point are sequentially connected to form a first polygonal line, the second vertex point, the sixth feature point, and the tenth feature point are sequentially connected to form a second polygonal line, the third vertex point, the seventh feature point, and the eleventh feature point are sequentially connected to form a third polygonal line, and the fourth vertex point, the eighth feature point, and the twelfth feature point are sequentially connected to form a fourth polygonal line;
when the feature trench is positioned between the second side wall and the current injection region, the feature trench spans over the third polygonal line and the fourth polygonal line in a length direction thereof; and when the feature trench is positioned between the first side wall and the current injection region, the feature trench spans over the first polygonal line and the second polygonal line in a length direction thereof.

24. The light emitting structure of an edge emitting semiconductor according to claim 23, wherein the threshold distance is in a range of 10 microns to 50 microns.

25. A method for manufacturing the light emitting structure of an edge emitting semiconductor according to any one of claims 1-24, comprising:
providing a semiconductor substrate layer;
sequentially forming a lower confinement layer, an active layer, and an upper confinement layer that are stacked on the semiconductor substrate layer;
wherein the light emitting structure of an edge emitting semiconductor is provided with a first side wall and a second side wall oppositely arranged, and the first side wall and the second side wall are distributed in a slow axis direction of the light emitting structure of an edge emitting semiconductor; and the light emitting structure of an edge emitting semiconductor is provided with a current injection region positioned between the first side wall and the second side wall, and the current injection region is spaced apart from both the first side wall and the second side wall; and
forming a feature trench at least on one side of the current injection region in the slow axis direction; wherein the feature trench is positioned at least in the upper confinement layer, the feature trench is provided with a feature side wall towards the current injection region, and the feature side wall and the current injection region are spaced apart in the slow axis direction; and a surface of the feature side wall is provided with a plurality of protrusions towards the current injection region.

26. The method according to claim 25 for manufacturing the light emitting structure of an edge emitting semiconductor, further comprising: forming a first etched trench and a second etched trench in part of the upper confinement layer in a thickness direction thereof before the feature trench is formed, wherein a portion, between the first etched trench and the second etched trench, of the upper confinement layer forms a ridge region; the ridge region and portions, under the ridge region, of the lower confinement layer, the lower waveguide layer, the active layer, the upper waveguide layer, and the upper confinement layer serve as the current injection region; and
the step of forming a feature trench comprises: forming the feature trench at the bottom of the first etched trench and/or the bottom of the second etched trench.

27. The method according to claim 25 for manufacturing the light emitting structure of an edge emitting semiconductor, further comprising: forming a lower waveguide layer on one side, facing away from the semiconductor substrate layer, of the lower confinement layer before the active layer is formed; and forming an upper waveguide layer on one side, facing away from the semiconductor substrate layer, of the active layer before the upper confinement layer is formed; wherein, in the step of forming a feature trench at least on one side of the current injection region in the slow axis direction, the feature trench is formed to be positioned at least in the upper waveguide layer and the upper confinement layer.
